# EUROPEAN PATENT SPECIFICATION

(11) **EP 0 349 989 B1**
(45) Date of publication and mention of the grant of the patent: **27.09.1995**
(21) Application number: 89112216.0
(22) Date of filing: 04.07.1989
(51) Int. Cl.: H04N 9/87, H04N 5/907

(54) **Field memory device for processing a color television signal including different two modulated color signals transmitted alternately for one horizontal period**
Halbbildspeichervorrichtung zum Verarbeiten eines Farbfernsehsignals mit zwei verschiedenen modulierten, zeilensequentiell übertragenen Farbsignalen
Dispositif mémoire de trame pour le traitement d'un signal de télévision en couleurs comprenant deux signaux de couleurs modulés différents transmis séquentiellement pour une période horizontale

(30) Priority: 05.07.1988 JP 167410/88
(43) Date of publication of application: 10.01.1990
(73) Proprietor: SANYO ELECTRIC CO., LTD., Moriguchi-shi, Osaka (JP)
(72) Inventor: Ide, Hirokazu, Osaka-shi Osaka-fu (JP); Sunagawa, Osami, Osaka-shi Osaka-fu (JP)
(74) Representative: Glawe, Delfs, Moll & Partner

(56) References cited:
- GB-A- 2 173 632
- PATENT ABSTRACTS OF JAPAN vol. 9, no. 136 (E-320), 12 June 1985; & JP-A-60020690

## Description

The present invention relates to field memory devices and more particularly to a field memory device to be used for processing a color television (TV) signal including different two modulated color signals transmitted alternately for one horizontal period, e.g., a color TV signal of the PAL (Phase Alternation by Line) system or the SECAM (Sequential Coulours à Memoire) system in a video tape recorder (VTR) or the like.

In the prior art, a VTR having a field memory device for storing a video signal for one field is practically utilized. Such a field memory device is used for obtaining a noiseless reproduced image in a special reproduction mode for example.

In a VTR of the PAL system, a field memory device for storing a PAL composite signal needs to satisfy the following conditions: at a junction of fields of the composite signal, (1) a horizontal synchronizing signal is continuous, (2) a color subcarrier is continuous, and (3) a burst sequence is continuous.

The above mentioned conditions of (1) and (2) are also required for a field memory device for storing a color video signal of the NTSC system. The condition of (2) can be fulfilled in a manner in which sampling at the time of writing a video signal in a memory is effected in phase lock to a subcarrier and the video signal is written into and read from the memory by using as a unit a period equal to an integral multiple of a color subcarrier period. The condition of (1) can be fulfilled in a manner in which the video signal is written into and read from the memory by using as a unit a period equal to an integral multiple of a period H of a horizontal synchronizing signal. Therefore, in order to satisfy the above mentioned conditions of (1) and (2) simultaneously in a conventional field memory device, a period most approximate to the period of the integral multiple of H out of the periods equal to the integral multiples of the period of the color subcarrier is selected as a unit period for writing and reading the video signal into and from the memory.

The above mentioned condition of (3) as to the burst sequence is a condition particularly required for a color video signal of the PAL system. As is well known, in the case of a color video signal of the PAL system, the phase of an R-Y component of a modulated color signal is inverted for each horizontal period H and accordingly, the phase of a burst signal changes alternately for one H by a phase difference of ± 135° from that of a B-Y component. Consequently, if the order of inversions of the phases of the burst signal for one H, namely, a burst sequence is disturbed, for example, if the phases of the burst signal are successively - 135° with respect to that of the B-Y component, correct colors can not be reproduced on a screen of the TV receiver.

The necessity for reproducing such alternate inversions of the burst signal phases in a regular order, namely, the necessity for attaining continuity of a burst sequence arises not only in such a field memory device as described above but also at the time of special reproduction in a VTR. For example, Japanese Patent Publication JP-A-5750117 discloses a technique in which if discontinuity of a burst sequence occurs in a special reproduction mode of a VTR, the discontinuity is detected and an output delayed by one H is selected to regain continuity of the burst sequence.

In addition, such necessity for making a burst sequence continuous occurs not only in the above described case of a color video signal of the PAL system but also in the case of transmitting two modulated color signals alternately for one H as in the case of a color video signal of the SECAM system.

Accordingly, in order to attain a continuous burst sequence as described above in a field memory device which stores a color video signal of the PAL system or the SECAM system, it may be considered to use a technique as indicated in the above mentioned Japanese patent Publication JP-A-5750117. However, in order to practically utilize such technique, it is necessary to provide means for determining discontinuity of a burst sequence or to provide 1H delay lines and the like. Consequently, a circuit configuration is complicated and it becomes difficult to adjust the circuit components, causing an increase in the manufacturing cost.

GB-A-2 173 632 describes a video information playback system utilizing a digital video memory for enabling special playback operations such as SLOW mode, STILL mode and FAST mode. In order to simplify the construction of the system, the frequency of write and read clock signals used in the digital video memory is n times the horizontal synchronizing signal frequency.

A field memory device according to the preamble of claim 1 is disclosed in "Patent Abstracts of Japan" vol. 9, no. 136 (E-320), & JP-A-60 020 690. In order to reduce memory requirements not all data included in a vertical blanking period of video signals are written in a field memory.

It is an object of the invention to provide a field memory device which can ensure continuity of a burst sequence at junctions of respective fields with a simple structure at the time of reading a composite signal from the field memory device.

This object is achieved by a field memory device as defined in claim 1; the dependent claims relate to further developments of the invention.

A principal advantage of the present invention is that if reading of the field memory is reset in the period 2nH (for example, 312H), a burst sequence can be made continuous between the last H period of a previous field and the first H period of the succeeding field with respect to a junction of those two fields as a boundary, making it possible to reproduce correct colors on a screen of a TV receiver.

The foregoing and other objects, features, aspects and advantages of the present invention will become more apparent from the following detailed description of the present invention when taken in conjunction with the accompanying drawings.

Fig. is a schematic block diagram showing a field memory device according to the present invention.

Fig. 2 is a block diagram showing a synchronous control circuit of a first embodiment of the invention in the field memory device shown in Fig. 1.

Fig. 3 is a timing chart showing a process of forming a signal RefB in the first embodiment of the invention.

Fig. 4 is a timing chart showing still reproduction operation in the first embodiment of the invention.

Figs. 5, 6, 7 and 8 are timing charts for explaining stroboscopic reproduction operation in the first embodiment of the invention.

Fig. 9 is a timing chart for explaining intermittent slow reproduction operation in the first embodiment of the invention.

Fig. 10 is a timing chart for explaining double-speed reproduction operation in the first embodiment of the invention.

Fig. 11 is a timing chart for explaining 1/3 slow reproduction operation in the first embodiment of the invention.

Fig. 12 is a block diagram showing an asynchronous control circuit of a second embodiment of the invention in the field memory device shown in Fig. 1.

Fig. 13 is a timing chart for explaining still reproduction operation in the second embodiment of the invention.

Fig. 14 is a timing chart for explaining stroboscopic reproduction operation in the second embodiment of the invention.

Figs. 15 and 16 are timing charts for explaining intermittent slow reproduction operation in the second embodiment of the invention.

Fig. 17 is a timing chart for explaining double-speed reproduction operation in the second embodiment of the invention.

Fig. 18 is a timing chart for explaining 1/3 slow reproduction operation in the second embodiment of the invention.

Figs. 19 and 20 are timing charts for explaining SKIP operation in the second embodiment of the invention.

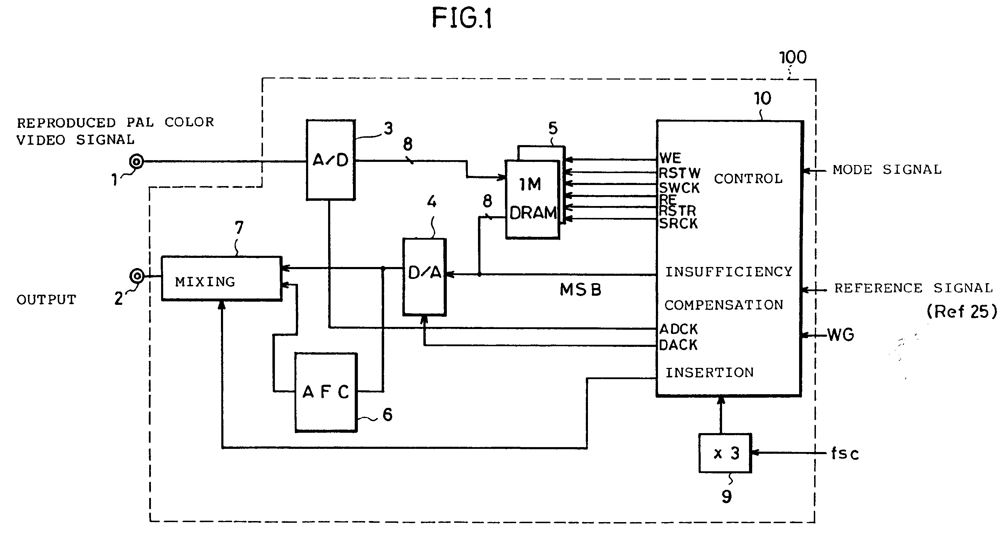

Fig. 1 is a schematic block diagram showing a field memory device according to the present invention.

Referring to Fig. 1, a video signal to be processed, e.g., a PAL color video signal reproduced in a VTR of the PAL system is applied to an input terminal 1 of the field memory device 100. The applied video signal is converted to a digital signal by an A/D converter 3 of 8 bits and the digital signal thus obtained is applied to a dynamic random access memory (DRAM) of 1M bit and stored therein. The video signal read from the DRAM 5 is converted to an analog signal by a D/A converter 4 of 8 bits and then the analog signal thus obtained is applied to an automatic frequency control signal (AFC) circuit 6 and to a mixing circuit 7. A control circuit 10 generates various control signals in response to a VTR reproduction mode signal and a write gate signal WG both supplied from a system control circuit not shown, a reference signal Ref25 of 25Hz supplied from a servo circuit not shown, and a signal of a frequency 3f_{SC} three times as large as a frequency f_{SC} of a color subcarrier of a reproduced video signal supplied from a triplicating circuit 9 and it applies generated control signals to the A/D converter 3, the DRAM 5 and the D/A converter 4, whereby writing/reading operation of the DRAM 5 is controlled. The AFC circuit 6 is provided to compensate for lack of a horizontal synchronizing signal in a video signal read from the DRAM 5, and an output of the AFC circuit 6 is mixed with an output of the D/A converter 4 in a mixing circuit 7. An output of the mixing circuit 7 is provided as a processed video signal through an output terminal 2.

The DRAM 5 includes two memories, TMS4C1050 of 256K x 4 bits of Japan Texas Instrument Co. Ltd., for example. Such a memory chip is described in detail in pages 154 to 155 of Nikkei Electronics, issued May 18, 1987 (Vol. 421). This memory chip has a function of internally generating an address only upon receipt of a serial clock signal and a reset signal. If writing and reading are carried out simultaneously, data written latest is not read unless a difference between a write address and a read address is larger than 600. Consequently, it is necessary to take suitable measures in the case of asynchronous reading in which reading does not synchronize with writing.

Let us consider a case of sampling a PAL color signal with a frequency 3f_{SC}. The number of samples for one field is 3f_{SC}/fv where fv represents a field frequency and fv = 50 in the case of the PAL system. Accordingly, the number of samples for one field is 3f_{SC}/fv = 3 x 4.43361875 x 10⁶/50 = 266017. Since the memory chip has 256K bytes, it contains only 262264 addresses and in order to store all the sample data of one field, it is short of 3753 addresses. If this shortage is considered in terms of horizontal lines, it substantially corresponds to data for 4.4 horizontal lines. For this reason, data for the lacking addresses are not written in the DRAM 5 as described later.

As for reading and writing operations of the DRAM 5 shown in Fig. 1, it is possible to perform two types of operations, namely, synchronous operation in which writing and reading synchronize and asynchronous operation in which writing and reading do not synchronize. The control circuit 10 can be adapted for those operations.

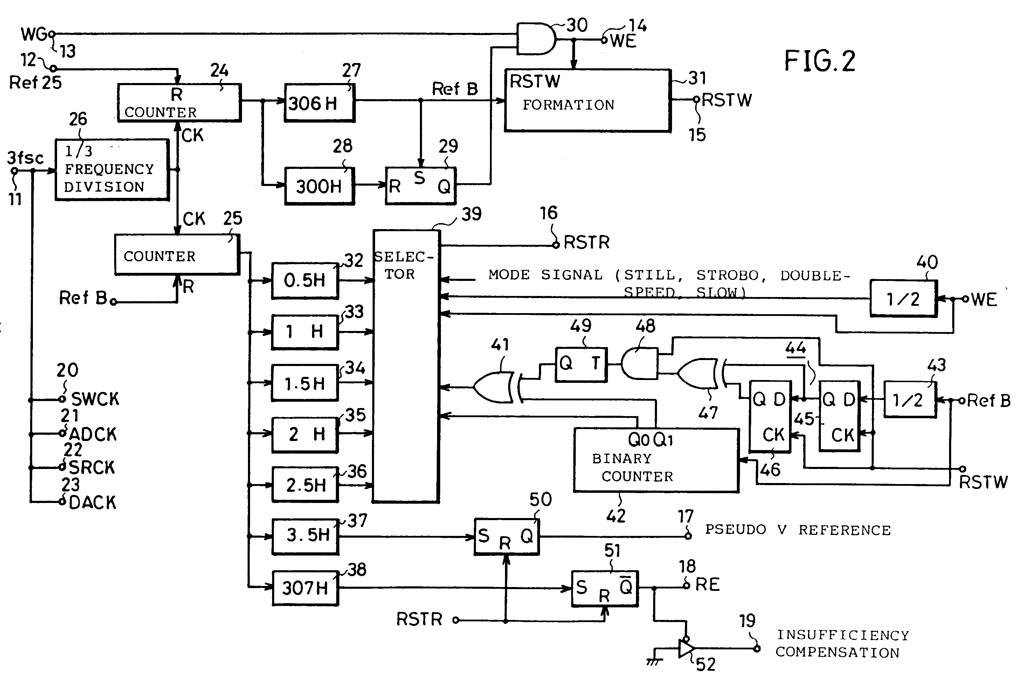

Fig. 2 is a block diagram showing a synchronous control circuit 10 as a first embodiment of the present invention, utilized in the field memory device of Fig. 1.

Referring to Fig. 2, a signal of a frequency 3f_{SC} applied from the triplicating circuit 9 in Fig. 1 is applied to a 1/3 frequency dividing circuit 26 and output terminals 20, 21, 22 and 23 through an input terminal 11. This 3f_{SC} signal is outputted from those output terminals as a serial write clock (SWCK) signal, an A/D clock (ADCK) signal, a serial read clock (SRCK) signal and a D/A clock (DACK) signal, respectively. The 1/3 frequency dividing circuit 26 applies 1/3 frequency division to the 3f_{SC} signal and supplies a signal thus obtained to a write counter 24 and a read counter 25 as clocks of the frequency f_{SC}, so that the write counter 24 and the read counter 25 count those clocks. The write counter 24 is reset by a 25Hz reference signal Ref25 supplied from a servo circuit not shown through the input terminal 12, and the read counter 25 is reset by a signal RefB to be described afterwards. The count output of the write counter 24 is supplied to a 306H decoder 27 and to a 300H decoder 28. The 306H decoder 27 is a circuit which outputs a pulse of a predetermined duration after 306H (an H being a horizontal period) from the resetting of the write counter 24 by the Ref25 signal, and the 300H decoder 28 is a circuit which outputs a pulse of a predetermined duration after 300H from the resetting. The output of the 306H decoder 27 is used as the above mentioned RefB signal. The RefB signal is applied to a set input of an R-S flip-flop 29 and to a write reset (RSTW) signal forming circuit 31. The RSTW signal forming circuit 31 outputs the write reset (RSTW) signal through an output terminal 15. On the other hand, the output of the 300H decoder 28 is applied to a reset input of the R-S flip-flop 29. More specifically, the R-S flip-flop 29 is reset by the output of the 300H decoder 28 and set by the output of the 306H decoder 27, and a Q output thereof is applied to one input of an AND gate 30. A write gate (WG) signal is applied to the other input of the AND gate 30 from a system control circuit, not shown, through an input terminal 13. An output of the AND gate 30 is applied to the RSTW signal forming circuit 31 as a write enable (WE) signal and is outputted through an output terminal 14.

In the meantime, the count output of the read counter 25 is supplied to a 0.5H decoder 32, a 1H decoder 33, a 1.5H decoder 34, a 2H decoder 35, a 2.5H decoder 36, a 3.5H decoder 37 and a 307H decoder 38. Outputs of the decoders 32, 33, 34, 35 and 36 out of those decoders are supplied to a selector 39 and the selector 39 selects any of those outputs and provides it as a read reset (RSTR) signal through an output terminal 16.

The selecting operation of the selector 39 is controlled by a mode signal from the system control circuit, namely, a signal instructing a specified one of reproduction modes and the like, a WE signal, a signal obtained by 1/2 frequency division of the WE signal by a 1/2 frequency dividing circuit 40, an output of an EX-OR gate 41 to be described later, and a Q₀ output of a binary counter 42.

More specifically stated, the RefB signal outputted from the 306H decoder 27 is applied to a 1/2 frequency dividing circuit 43 and to the binary counter 42. An output of a 1/2 frequency dividing circuit 43 is supplied as a data input to a 2-stage shift register 44 including flip-flops 45 and 46. The RSTW signal is supplied as a clock to the shift register 44 from the RSTW signal forming circuit 31. Respective Q outputs of the D-flip-flops 45 and 46, namely, two outputs of the shift register 44 are supplied to inputs of a first EX-OR gate 47. An output of the first EX-OR gate 47 is supplied to one input of an AND gate 48 and the RSTW signal (delayed with a predetermined period as required) is supplied to the other input thereof. An output of the AND gate 48 is supplied to a T-flip-flop 49 and triggers this flip-flop 49. On the other hand, the binary counter 42 counts the RefB signal inputted and it provides an output Q₁ to one input of a second EX-OR gate 41 and an output Q₀ to the selector 39. A Q output of the T-flip-flop 49 is supplied to the other input of the second EX-OR gate 41, and an output of the second EX-OR gate 41 is supplied to the selector 39.

Meanwhile, an output of the 3.5H decoder 37 is supplied to a set input of an R-S flip-flop 50 and an output of the 307H decoder 38 is supplied to a set input of an R-S flip-flop 51. The read reset (RSTR) signal from the terminal 16 is supplied to respective reset inputs of the R-S flip-flops 50 and 51. A Q output of the R-S flip-flop 50 is supplied as a pseudo vertical synchronizing signal reference through an output terminal 17, and a Q̅ output of the R-S flip-flop 51 is supplied as a read enable (RE) signal through an output terminal 18. An output of a buffer 52 controlled by the RE signal is supplied an insufficiency compensation signal through an output terminal 19.

Now, operation of the first embodiment of the invention shown in Fig. 2 will be described. Special reproduction operation of a VTR to which a field memory device of the present invention is applied includes still reproduction (memory reproduction), stroboscopic reproduction, intermittent slow reproduction, double-speed reproduction, and 1/3 slow reproduction.

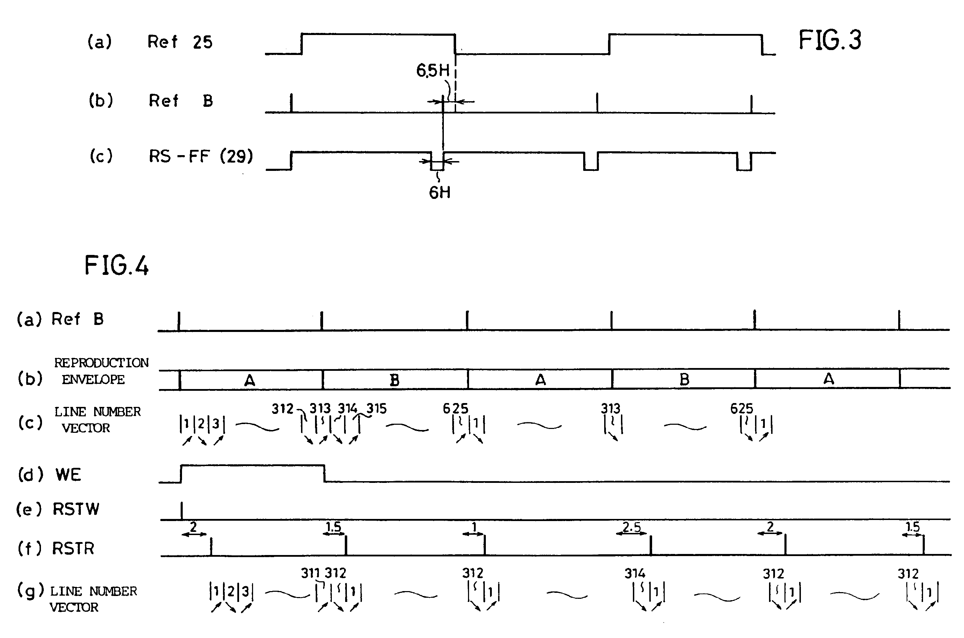

Among those special reproductions, still reproduction operation will be first described with reference to the timing charts of Figs. 3 and 4. In still reproduction, when an instruction is issued from the system control circuit in a normal reproduction state in which the tape runs, a video signal for about one field is written in the memory and the running of the tape is thereafter stopped. Still reproduction is effected by repeatedly reading the written video signal.

The writing of the video signal into the DRAM 5 in Fig. 1 is controlled by the write enable (WE) signal, the write reset (RSTW) signal and a serial write clock (SWCK) signal supplied from the control circuit in Fig. 2. Referring to Fig. 2, the Ref25 signal supplied to the control circuit 10 through the input terminal 12 is a signal (as shown in (a) of Fig. 3) generated by the servo circuit not shown, and rotation of a pair of rotating heads (not shown) is phase-locked to the Ref25 signal. Edges of rise and fall of the Ref25 signal correspond to phases of a vertical synchronizing signal.

In such special reproduction, in order to insert a pseudo vertical synchronizing signal (hereinafter referred to as pseudo V into a reproduced video signal, it is necessary to insert it with a timing applied prior to normal timing of the vertical synchronizing signal. Accordingly, the 306H decoder 27 forms the RefB signal (as shown in (b) of Fig. 3) which defines a timing preceding by 6.5H the timing of the vertical synchronizing signal. Thus, since the number of lines for one field is 312.5, the pulse generated after 306H's from the edge of the Ref25 signal synchronizing with the vertical synchronizing signal has a timing to be applied prior to the subsequent vertical synchronizing signal by (312.H - 306H = 6.5H).

Since the R-S flip-flop 29 is set by the RefB signal and reset by the output of the 300H decoder 28, it provides the Q output as shown in (c) of Fig. 3. Thus, it outputs a signal having H level in a period shorter than the 1-field period by 6H. This signal as well as the write gate (WG) signal applied from the system control circuit through the terminal 13 is processed by the AND gate 30. The WG signal is a signal for controlling opening and closing of the AND gate 30 so that the field stored in the memory (DRAM) 5 may correspond to the output of one (A) of the heads of the pair without fail. The output of the AND gate 30 is supplied as the write enable (WE) signal. Thus, the duration of the WE signal is shorter than the 1-field period by 6H because the capacity of the memory 5 is insufficient for the data corresponding to about 4.4H and writing of excess data should be avoided.

The RSTW signal forming circuit 31 delays the RefB signal by a predetermined period and processes this signal together with the WE signal through the gates, whereby the RSTW signal is formed and supplied through the terminal 15.

First, when the still reproduction mode is instructed, a reproduced output for about one field is stored in the field memory device in a normal reproduction condition in which the tape is running. Actual writing operation in the memory 5 is automatically carried out only by applying the WE signal, the SWCK signal and the RSTW signal from the control circuit 10 to the memory 5. Then, the first field A shown in Fig. 4 for example is written in the memory 5. Although the WE signal of Fig. 4 (c) is represented as continuing for the whole of the first field A for the purpose of simplifying the explanation, it is actually shorter than the 1-field period by 6H's as described previously.

In reading from the memory 5, the selector 39 selects successively the outputs of the 2H decoder 35, the 1.5H decoder 34, the 1H decoder 33 and the 2.5H decoder 36 in response to 2-bit outputs Q₀ and Q₁ of the binary counter 42 counting the RefB signal and supplies those outputs as the RSTR signal.

As a result, as shown in (f) of Fig. 4, a delay amount of the RSTW signal from the RefB signal changes in the sequence of 2H, 1.5H, 1H and 2.5H and the field periods read successively are 2n (n being a positive integer) multiples of the horizontal synchronizing signal H, such as 312H, 312H, 314H and 312H, respectively. Accordingly, in the case of a reproduced video signal in which vectors of burst are inverted alternately as shown in (c) of Fig. 4, the burst sequence becomes continuous at junctions of fields repeatedly read as shown in (g) of Fig. 4.

More specifically, according to the above described embodiment, read reset pulses at intervals of 312H's or 314H are formed based on the RefB signal outputted at fixed intervals of 312.5H, whereby the burst sequence can be made continuous.

The above described still reproduction operation can be applied not only in the case of using a reproduced video signal of a VTR but also in the case of displaying a still image by writing a broadcast video signal into a field memory and repeatedly reading the signal.

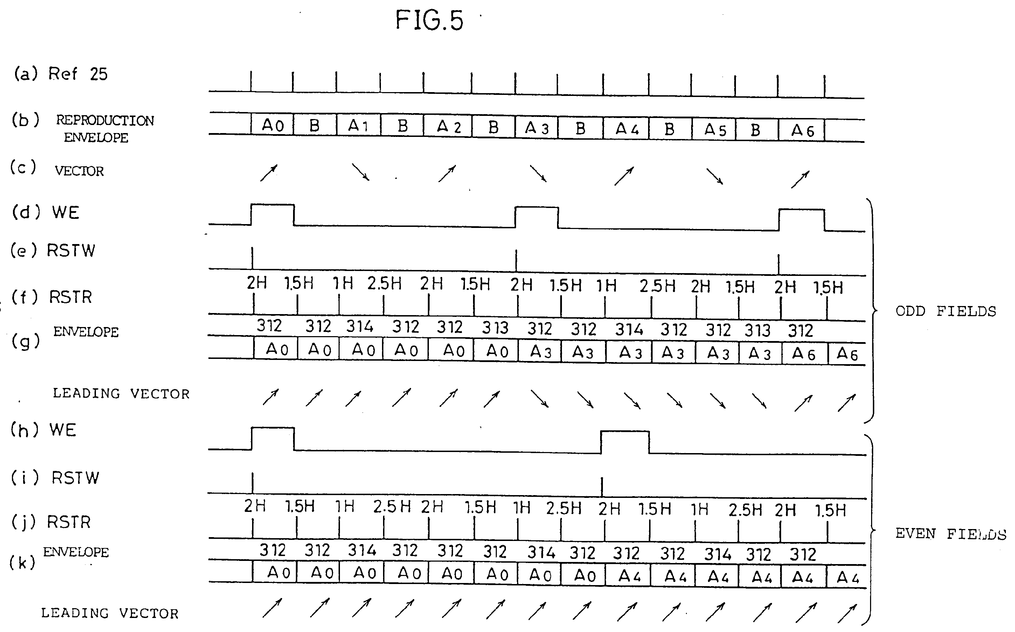

Next, stroboscopic reproduction operation will be described with reference to the timing chart of Fig. 5. In stroboscopic reproduction operation, a reproduced video signal is stored in the memory intermittently, for example, for every three or four frames while the tape is running in the same manner as in the normal reproduction mode, and the stored video signal is repeatedly read until the subsequent storing is made, whereby intermittent movement on the reproduced image can be realized. Referring to Fig. 5, (d) to (g) represent cases of writing a reproduced video signal of the leading field for a unit of an odd number of frames (three frames) in the memory, and (h) to (k) represent cases of writing, in the memory, a reproduced video signal of the leading field for a unit of an even number of frames (four frames).

In the case of using an even number of frames as a unit of writing operation (in (h) to (k) of Fig. 4), that is, in the case in which a signal of a field A₄ is stored subsequently to a field A₀, intervals of read reset pulses RSTR are defined by the same sequence as that of the above mentioned still reproduction, whereby the burst sequence can be made continuous.

In the case of using an odd number of frames as a unit of writing operation (as shown in (d) to (g) of Fig. 4), that is, in the case in which a signal of a field A₃ is stored subsequently to the field A₀, the first burst vector of the field A₃ to be written is not continuous with the last burst vector of the field read immediately before the writing according to the above described sequence. Therefore, in such a case, a high-order bit Q₁ of the binary counter 42 is inverted, whereby the sequence of delay of the RSTR signal is advanced for two fields. Thus, although an interval of read reset pulses is set to 312H or 314H according to the previously mentioned sequence, an interval of reset pulses for only the field immediately before the writing is set to 313H in this case, so that the burst sequence at a junction with the subsequent field can be made continuous.

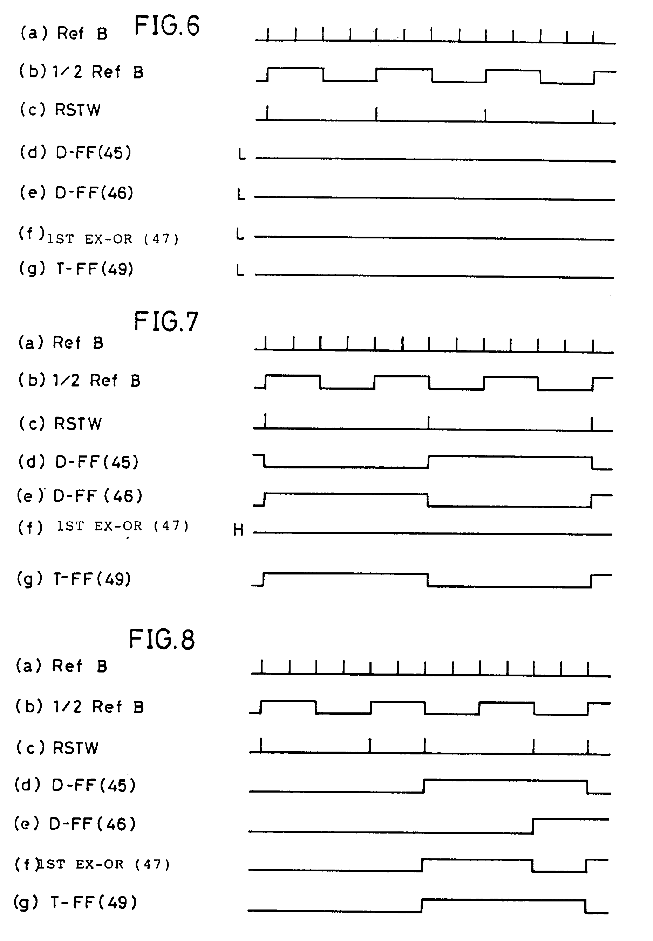

Such determination of intervals of reset pulses is effected based on the states of the outputs of the 2-stage shift register 44 which receives a square wave signal obtained by 1/2 frequency division of the RefB signal by the 1/2 frequency dividing circuit 43 as a data input and the RSTW signal as a clock. Figs. 6 to 8 are timing charts for explaining such determination.

First, if an even number of frames are used as a unit of writing operation, the levels latched at the D-flip-flops 45 and 46 are constantly the same level (as shown in (d) and (e) of Fig. 6). Accordingly, the output of the EX-OR gate 47 is constantly at L level (as shown in (f) of Fig. 6). In consequence, the output of the binary counter 42 is applied directly to the selector 39 and the sequence for decoder selection for forming the RSTR signal is set to the same sequence as that in the above described still reproduction.

Conversely, if an odd number of frames are used as a unit of writing operation, the levels latched at the D-flip-flops 45 and 46 for each RSTW signal are different (as shown in (d) and (e) of Fig. 7). Accordingly, the output of the EX-OR gate 47 is constantly at H level (as shown in (f) of Fig. 7). As a result, the T-flip-flop 49 is triggered by the RSTW signal and the output of the T-flip-flop 49 is inverted each time writing is carried out. Thus, the Q₁ output of the binary counter 42 is directly supplied to the selector 39 or is inverted to be supplied thereto. In consequence, as shown in (f) of Fig. 5, the sequence of delay of the RSTR signal is advanced for two fields each time writing is carried out, whereby the burst sequence can be made continuous.

In addition, if an odd number of frames and an even number of frames are used in a mix manner as a unit of writing, the output Q₁ of the binary counter 42 is inverted in the subsequent writing if writing has been carried out by using the odd number of frames as a unit, and the output Q₁ is maintained as it is in the subsequent writing if writing has been carried out by using the even number of frames as a unit, as shown in Fig. 8.

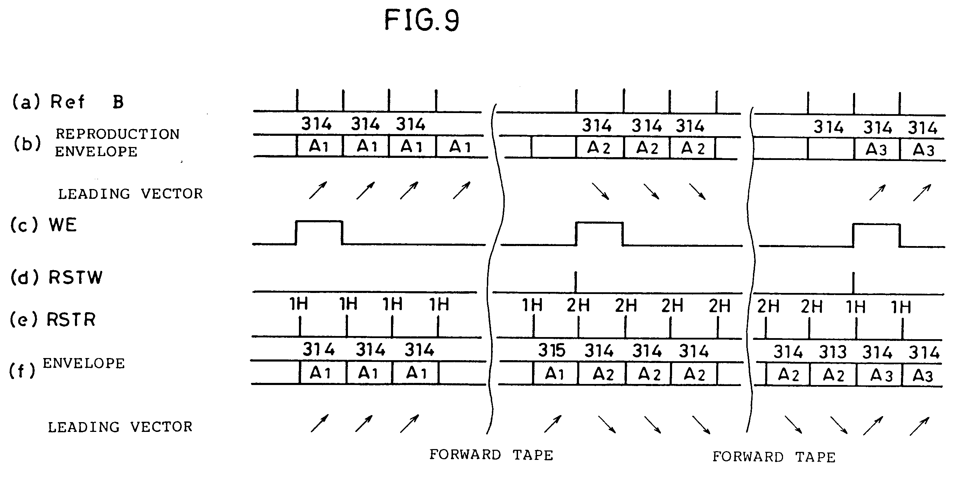

Next, intermittent slow reproduction operation will be described with reference to the timing chart of Fig. 9. In intermittent slow reproduction, the above described still reproduction using the memory and normal reproduction are repeated alternately. According to this embodiment, as shown in Fig. 9, after the field A₁ has been reproduced in the still mode, the tape is caused to run and the field A₂ is reproduced in the still mode. Such running of the tape is started with timing related with RF switching pulses and it is stopped at the third RF switching pulse from the start. Then, the content of the memory 5 is rewritten with this timing. The above described control is effected in response to the WG signal from the system control circuit.

In a standard mode of a VTR of the VHS-PAL system according to this embodiment, a relative speed for recording and that for reproduction are different and accordingly the number of horizontal synchronizing signals in one field period in the still reproduction is 314. Therefore, correction of the H period is not required in the case of simply writing and reading a video signal into and from the memory. However, in order to prevent the content of the memory from being broken, the RSTR signal is delayed from the RSTW signal by 1H or 2H's. Accordingly, since writing operation is effected with respect to a video signal for every other field, the burst sequence is not readily consistent. Therefore, the 1/2 frequency dividing circuit 40 applies 1/2 frequency division to the WE signal and supplies the output thus obtained to the selector 39, so that the selector 39 selects the output of the 1H decoder 33 or the output of the 2H decoder 35 according to H level or L level of the output of the 1/2 frequency division. As a result, the burst sequence at the junctions of the fields becomes continuous (as shown in (f) of Fig. 9).

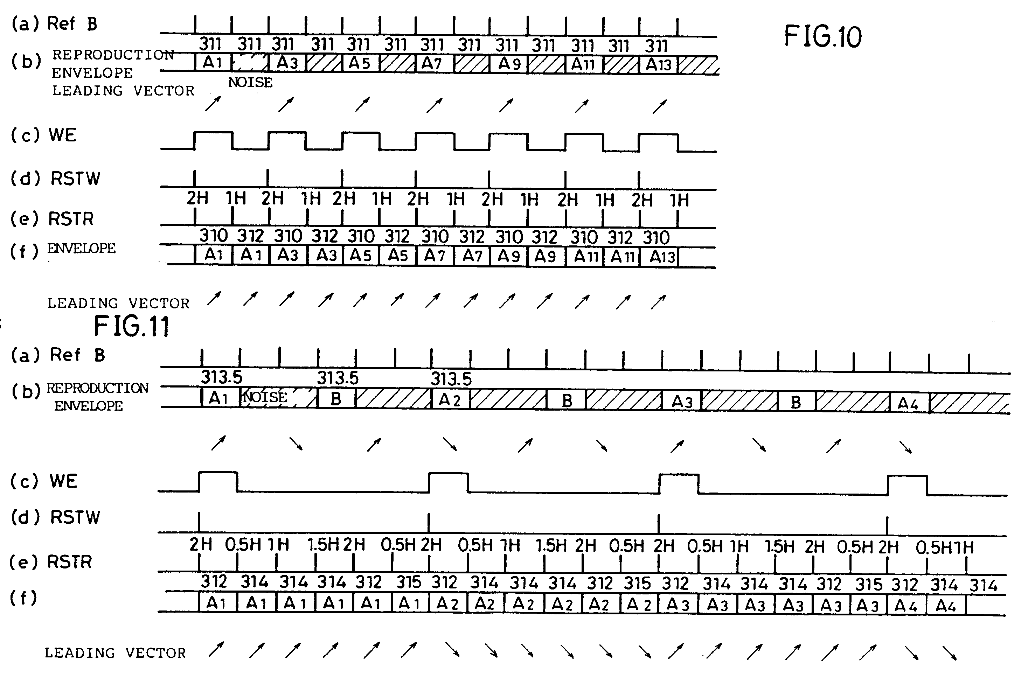

Next, double-speed reproduction operation will be described with reference to the timing chart of Fig. 10. In the double-speed reproduction operation, the running speed of the tape is set to a value twice that in normal reproduction and the phase of running of the tape is controlled so that odd-numbered tracks out of the tracks formed on the tape by the A head can be correctly traced. Thus, the odd-numbered fields are written into and read from the memory.

In the standard reproduction mode of the VTR of the VHS-PAL system according to this embodiment, the number of scanning lines for the 1-field period is 311. Consequently, the selector 39 selects alternately the outputs of the 1H decoder 33 and the 2H decoder 35 in response to the WE signal and thus each field corresponds to 310H or 312H, thereby making continuous the burst sequence at the junctions of the fields (as shown (f) of Fig. 10).

Next, 1/3 slow reproduction operation will be described with reference to the timing chart of Fig. 11. In the 1/3 slow reproduction operation, the tape is caused to run continuously at a speed equal to 1/3 of the running speed in normal reproduction. In the case of the 1/3 slow reproduction, a reproduced output is obtained for a period of three fields as shown in (b) of Fig. 11. Then, only the outputs reproduced by the A head out of the reproduced outputs are written in the memory 5 (as shown in (c) of Fig. 11).

In the standard reproduction mode of the VTR of the VHS-PAL system according to this embodiment, the 1-field period corresponds to 313.5H. Accordingly, the selector 39 is controlled to select the RSTR signal in the same sequence as that in the above described still reproduction. Practically, the selector 39 selects the outputs of the 2H decoder 35, the 0.5H decoder 32, the 1H decoder 33 and the 1.5H decoder 34 in this order and provides those outputs as the RSTR signal. In consequence, the intervals of reset pulses corresponding to the respective fields are defined as 312H, 314H, 314H and 314H successively.

In addition, since the burst sequence is inverted for each of the written fields A₁, A₂, A₃ etc. in the same manner as in the above described stroboscopic reproduction (as shown in (b) of Fig. 11), the Q₁ output of the binary counter 42 is inverted so as to be supplied to the selector 39 or it is supplied directly to the selector 39 for each writing operation and the sequence for selection of the RSTR signal is shifted by two fields. Thus, since the unit of writing in the 1/3 slow reproduction is the same as in the case of writing for an odd number of frames in the above described stroboscopic reproduction, the elements 41 to 49 for the above described stroboscopic reproduction can be utilized without any change.

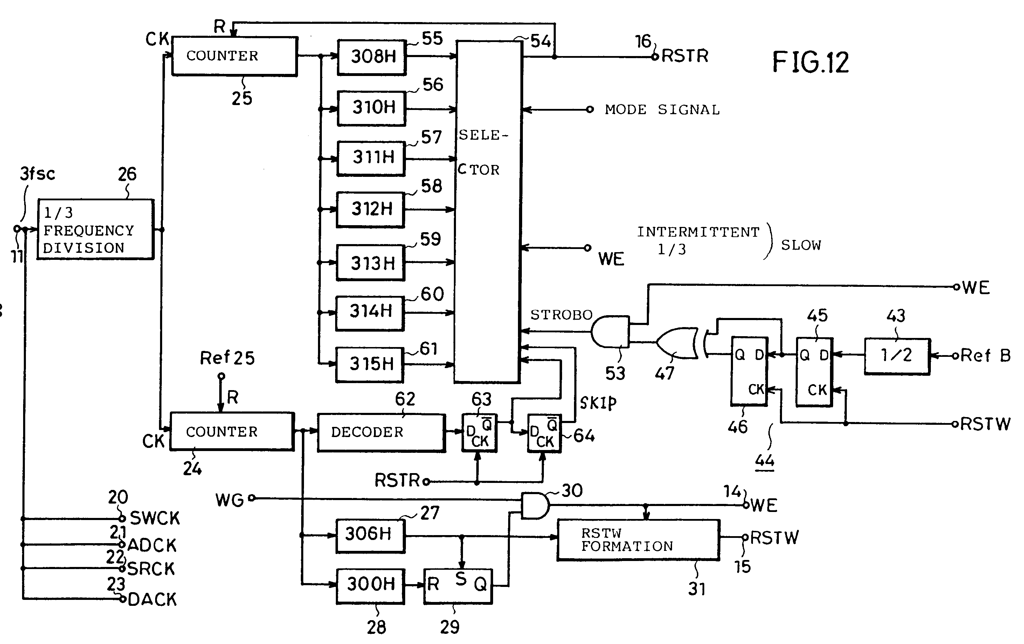

Fig. 12 is a block diagram showing an asynchronous control circuit 10 as a second embodiment of the invention, used in the field memory device of Fig. 1. Asynchronous operation is operation in which writing and reading for the memory 5 do not synchronize. As for the elements in Fig. 12 identical to those of the synchronous control circuit 10 in Fig. 2, the description is not repeated.

Referring to Fig. 12, an output of the read counter 25 is supplied to a 308H decoder 55, a 310H decoder 56, a 311H decoder 57, a 312H decoder 58, a 313H decoder 59, a 314H decoder 60 and a 315H decoder 61. The respective outputs of those decoders 55 to 61 are selected by a selector 54 and provided as the RSTR signal through the terminal 16. The selection operation of the selector 54 is controlled by the mode signal from the system control circuit, the WE signal, an output of an AND gate 53 provided for control in stroboscopic reproduction, and a SKIP signal to be described afterwards. The read counter 25 is reset by the RSTR signal as is different from the case of the above described synchronous system.

A circuit configuration for control of the selector 54 in stroboscopic reproduction is substantially the same as that for control of the selector 39 shown in Fig. 2, except for the below described points. An output of the EX-OR gate 47 receiving two outputs of the register 44, and the WE signal are supplied to inputs of the AND gate 53 and an output of the AND gate 53 is supplied to the selector 54.

In the case of asynchronous operation, it may happen that the timing of application of the RSTW signal and that of the RSTR signal become close to each other, causing a failure to read the content written immediately before the reading time, namely, a breakage in the content. Therefore, according to the second embodiment shown in Fig. 12, a SKIP signal is formed in the below described manner in order to change the timing of application of the RSTR signal in such a case. More specifically, an output of the write counter 24 is supplied to the decoder 62 and the decoder 62 generates "a signal indicating a dangerous region" in response thereto and supplies it as a data input to D-Flip-flops 63 and 64 constituting a two-stage shift register. The D-flip-flops 63 and 64 receive the RSTR signal as clock inputs. Outputs of the D-flip-flops 63 and 64 are supplied to the selector 54 as the SKIP signal.

Now, operation of the second embodiment of the present invention shown in Fig. 12 will be described.

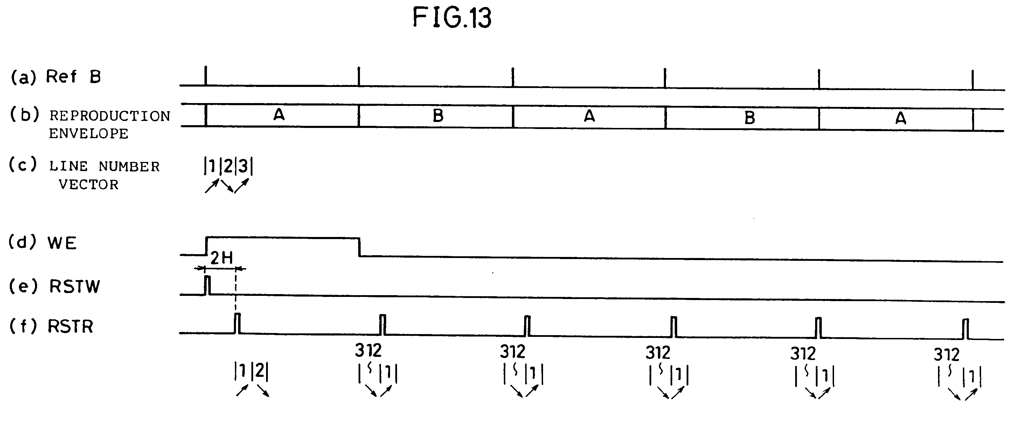

First, still reproduction operation will be described with reference to the timing chart of Fig. 13. In the still reproduction operation, once a video signal is written, only reading operation is repeatedly carried out thereafter (as shown in (d) of Fig. 13). Therefore, if the still reproduction is instructed by the mode signal, the output of the 312H decoder 58 is selected by the selector 54 to be outputted as the RSTR signal so that a period of read reset pulses, namely, a period of the RSTR signal may be 312 H. The relation between the RSTW signal (as shown in (e) of Fig. 13) and the RSTR signal (as shown in (f) of Fig. 13) does not involve the above described problem inherent in asynchronous operation if those signals are distant from each other by more than 2H's corresponding to 600 addresses in the first field. In order to ensure such distance, a 2H decoder (not shown) for receiving the output of the write counter 24 for example is provided, whereby an output of the 2H decoder is used for the first RSTR signal after a start of still reproduction and at the same time it is utilized for the first resetting of the counter 25.

As described above, since the period of reset pulses is defined as 312H in the still reproduction mode, the burst sequence at the junctions of the fields can be made continuous.

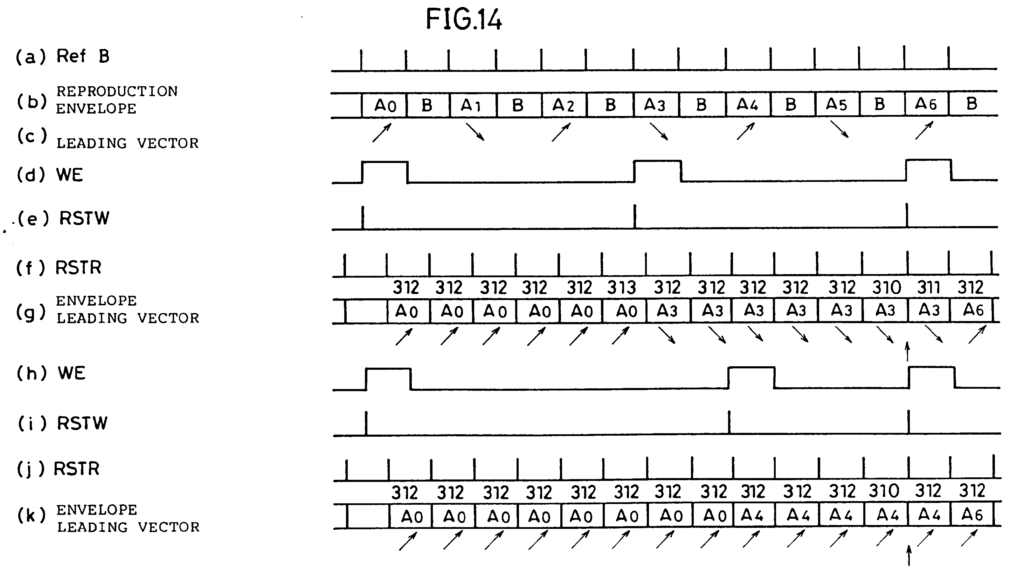

Next, stroboscopic reproduction operation will be described with reference to the timing chart of Fig. 14. The stroboscopic reproduction mode includes two cases, namely, the case of using an odd number of frames as one cycle of writing/reading, and the case of using an even number of frames as one cycle of writing/reading. In the case of using an even number of frames as one cycle of writing/reading, a cycle of a read reset pulse signal is set to 312H so that the burst sequence can be made continuous. In the case of using an odd number of frames as one cycle of writing/reading, a cycle of a read reset pulse immediately before writing operation is set to 313H so that the burst sequence can be made continuous. The defining of the odd number of frames as one cycle of writing/reading is determined by the shift register 44 and the EX-OR gate 47 and, based on this determination, application of the WE signal to the selector 54 is controlled by the AND gate 53. As a result, an output of the 313H decoder 59 is selected and the period of the RSTR signal is changed to 313H (as shown in (f) of Fig. 14).

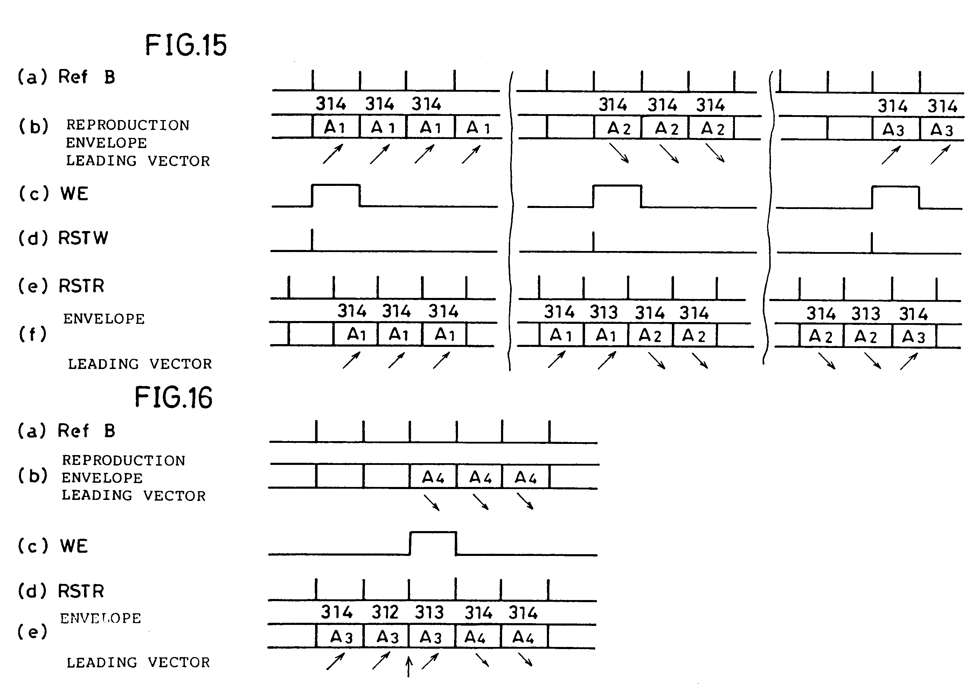

Next, intermittent slow reproduction operation will be described with reference to the timing charts of Figs. 15 and 16.

Since the 1-field period in intermittent slow reproduction is set to 314H as described previously, correction of the field period is in principle not needed. However, since writing operation is effected for a video signal of every other field as in the case of synchronous operation, the burst sequence is not readily consistent. Consequently, when the WE signal is at H level, the selector 54 selects the output of the 313H decoder 59 and supplies it as the RSTR signal. As a result, the burst sequence at junctions of fields can be made continuous.

Next, double-speed reproduction operation will be described with reference to the timing chart of Fig. 17. In double-speed reproduction, the 1-field period is set to 311H as in the above described case of synchronous operation. Accordingly, the selector 54 selects the output of the 310H decoder 56 and an interval of read reset pulses corresponds to 310H. Thus, the burst sequence can be made continuous.

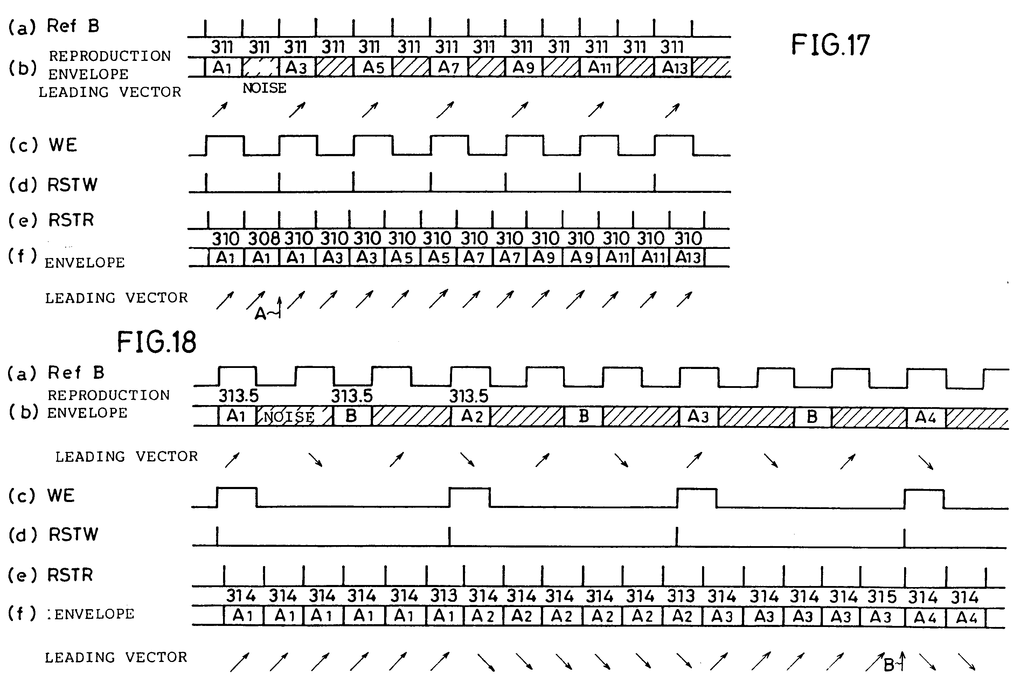

Next, 1/3 slow reproduction operation will be described with reference to the timing chart of Fig. 18. In 1/3 slow reproduction, the 1-field period is set to 313.5H as in the above described case of synchronous operation. Accordingly, the selector 54 selects the output of the 314H decoder 60 as the RSRT signal to define the cycle of 314H approximate to the period of 313.5H However, the burst phase is inverted for each field written and, accordingly, if the WE signal is at H level, the selector 54 selects the output of the 313H decoder 59, whereby the interval of read reset pulses is corrected.

Now, SKIP operation according to the second embodiment of the invention will be described. As described previously, the DRAM 5 used in this embodiment is of a type in which a stored content is liable to be broken if the difference of read and write addresses is smaller than 600. Accordingly, if a period corresponding to the difference between the RSRT signal and the RSTW signal becomes smaller than a period corresponding to 600 addresses, it is necessary to change the timing of application of the RSTR signal.

First, in the case of still reproduction, writing in the memory is effected only once and accordingly SKIP operation is not required if the RSTR signal and the RSTW signal are distant from each other by 2H in the first field as described above.

In the meantime, the dangerous region detecting decoder 62 provides an output of L level in a period of about 2H from the application of the RSTW signal. This period is defined such that the difference between the read and write addresses is always smaller than 600 at the time of the subsequent application of the RSTR signal if the RSTR signal is involved in the period.

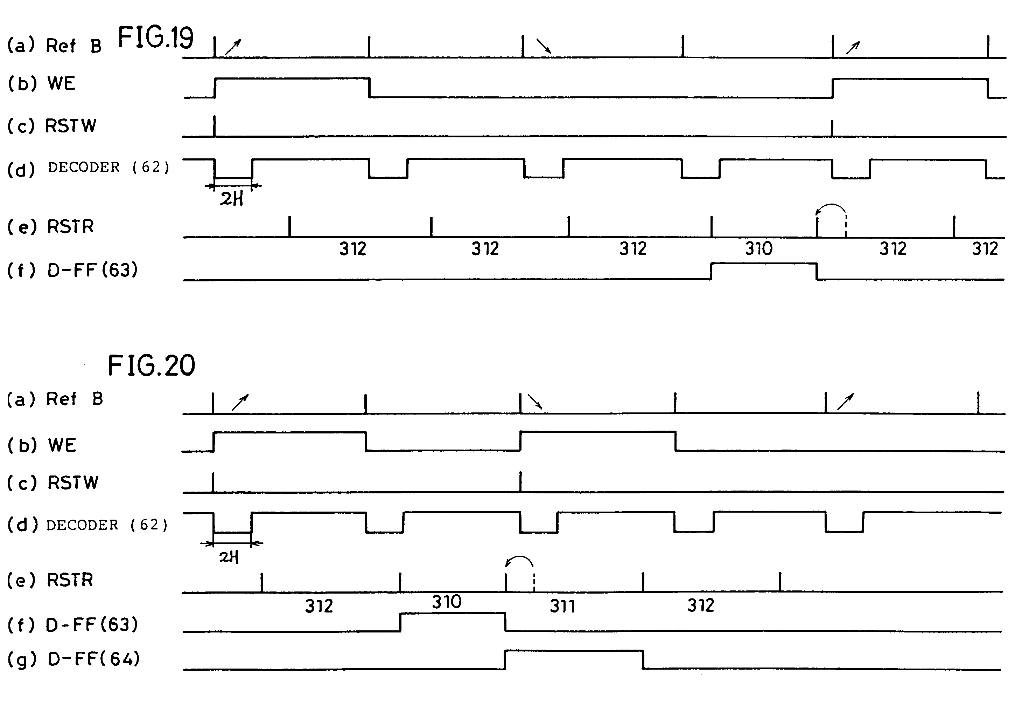

In stroboscopic reproduction, if an even number of frames are used as a cycle of writing/reading, the selector 54 selects the output of the 310H decoder 56 as the RSTR signal and outputs it when the RSTR signal is received in the above mentioned period of 2H and the Q̅ output of the flip-flop 63 is at H level (as shown in (e) of Fig. 19). If an odd number of frames are used as a cycle of writing/reading, the selector 54 selects the output of the 313H decoder 59 when the WE signal is at H level as described above. However, if SKIP operation is to be carried out immediately before the selection, the selector 54 selects the output of the 310H decoder 56 if the Q̅ output of the D-flip-flop 63 is at H level, and selects the output of the 311H decoder 57 if the Q̅ output of the D-flip-flop 64 is at H level, whereby the burst sequence is caused to be continuous.

Next, in double-speed reproduction operation, the output of the 308H decoder 55 is selected by SKIP operation (as shown by the arrow A in (f) of Fig. 17). In 1/3 slow reproduction, the output of the 315H decoder 61 is selected by SKIP operation (as shown by the arrow B in (f) of Fig. 18).

In intermittent slow reproduction, the intervals of read reset pulses are changed in the order of 314H, 312H, 313H and 314H, based on the outputs of the D-flip-flops 63 and 64 in the same manner as in the case of using an odd number of frames as a cycle of writing/reading in stroboscopic reproduction.

Next, insufficiency compensation operation according to the present invention will be described. As described previously, if a color TV signal of the PAL system is sampled by 3f_{SC}, the capacity of the memory becomes insufficient and, accordingly, masking is effected at the time of writing by using the WE signal shorter than the 1-field period by 6H. Further, for the purpose of not providing improper data from the memory at the time of reading, the read enable (RE) signal (namely, the output of the R-S flip-flop 51 in Fig. 2) is set to H level for a period of 307H in one field.

The RE signal is supplied as a control signal to a buffer 52 formed by a tri-state gate 74HC267. An output of the buffer 52 is wired OR connected with an MSB output of the DRAM 5. In addition, the 8-bit output of the DRAM 5 is pulled up in advance.

When the RE signal from the control circuit 10 is at L level in the DRAM 5, the output of the buffer 52 attains L level and the output of the DRAM 5 is brought into a high-impedance state. Therefore, if the RE signal is at L level, a fixed value (0 1 1 1 1 1 1 1) is outputted as the output of the DRAM 5. On the other hand, if the RE signal is at H level, the output of the buffer 52 is brought into a high-impedance state and no influence is exerted on the output of the DRAM 5.

Further, since the output of the DRAM 5 is a fixed value and the horizontal synchronizing signal disappears when the RE signal is at L level, the horizontal synchronizing signal from the AFC circuit 6 is mixed with the output of the DRAM 5 by the mixing circuit 7 in the period of L level of the RE signal. This mixing operation is effected in both of synchronous operation and asynchronous operation.

On the other hand, the pseudo V signal outputted from the terminal 17 in Fig. 2 is the output of the R-S flip-flop 50 and it is inserted in a reproduced video signal by the mixing circuit 7 for the purposes of preventing irregular change of the phases of the horizontal synchronizing signal, caused by a change of the 1-field period.

The foregoing description is related with the standard mode of the VTR of the VHS-PAL system; however, it is also applicable to a long-period mode. In the case of synchronous operation in a long-period mode, it is necessary to additionally provide decoders for a necessary delay amount, while in the case of asynchronous operation in a long-period mode, such delay means is not required.

More specifically, in synchronous operation, a sequence of delay as described below is required. First, in intermittent slow reproduction, the 1-field period in still reproduction is equal to 313 1/4H and accordingly the following sequence is required.
1H ―> 1 3/4H ―> 2 1/2H ―> 3 1/4H ―> 4H ―> 4 3/4H ―> 5 1/2H ―> 6 1/4H ―> 1H

In double-speed reproduction, the 1-field period is equal to 311 3/4H and accordingly the following sequence is required.
1H ―> 1 1/4H ―> 1 1/2H ―> 1 3/4H ―> 2H ―> 2 1/4H ―> 2 1/2H ―> 2 3/4H ―> 1H

In 1/3 slow reproduction, the 1-field period is equal to 313H's and accordingly the following sequence is required.
1H ―> 2H ―> 1H ―> 2H

There is no difference between the standard mode and the long-period mode in still reproduction and stroboscopic reproduction.

The present invention is applicable not only to a color TV signal of the PAL system as described above but also to a color TV signal of the SECAM system. More specifically, in the case of the SECAM system, two color signals are transmitted alternately for each scanning line according to a line sequential system and, accordingly, if a disturbance occurs in this transmission sequence, a lack of colors is liable to occur on a reproduced image of the television receiver. Since two color signals are alternately transmitted in this SECAM system, control may be effected so that the number of lines of a video signal to be read from the memory may be an even number, in the same manner as in the above described case of the PAL system.

As described in the foregoing, according to the embodiments of the present invention, reading of the field memory is reset for a period equal to an even number multiple of the horizontal period H, whereby the sequence of modulated color signals can be made continuous with a simple structure and correct colors can be reproduced on the TV receiver.

## Claims

1. A field memory device comprising: means (1) for supplying a color television signal in which two different modulated color signals are transmitted, whereby in each line period one of said two different modulated color signals is transmitted, such that the said two different modulated color signals alternate every line period; A/D converting means (3) for A/D conversion of said color television signal; a memory (5) for storing said color television signal obtained by the A/D conversion for substantially one field; means (4) for D/A conversion of the color television signal read from said memory, to output a signal obtained by the D/A conversion; and means (10) for controlling writing and reading of said color television signal into and from said memory, **characterized in** that:
said control means (10) defines a period nH obtained by multiplication of a horizontal period H by a number n near the number of scanning lines constituting one field of said color television signal and resets reading operation of said memory, after a period of substantially nH, n being a positive integer, and that at least in some modes of operation the period of nH between the read resets is varied by changing n in order to ensure continuity of color burst signal.

2. A field memory device in accordance with claim 1, wherein
writing of said color television signal into said memory (5) and reading of said color television signal from said memory are carried out synchronously.

3. A field memory device in accordance with claim 2, wherein
said control means (10) comprises
means (31) for generating a signal (RSTW) for resetting the write operation of said color television signal into said memory (5) and
means (39) for generating a signal (RSTR) for resetting the reading operation of said color television signal from said memory (5) with timing related with said writing reset signal, and
said reading reset signal generating means (38) comprises
means for delaying timing of generation of said reset signal to cause an interval of the reading reset signals successively generated to be equal to nH.

4. A field memory device in accordance with claim 3, wherein
said reading reset signal generating means (39) comprises
means for delaying timing of generation of said reset signal to cause an interval of the reading reset signals in reading operation immediately before writing into said memory to be equal to (2m + 1) H near to nH, m being a positive integer.

5. A field memory device in accordance with claim 1, wherein
writing of said color television signal into said memory (5) and reading of said color television signal from said memory (5) are carried out asynchronously.

6. A field memory device in accordance with claim 5, wherein
said control means (10) comprises
means (31) for generating a signal (RSTW) for resetting the writing of said color television signal into said memory (5), and
means (54) for generating a signal for resetting the reading (RSTR) of said color television signal from said memory (5) with timing independent of said writing reset signal, and
said reading reset signal generating means comprises
means for delaying timing of generation of said reset signal to cause an interval of the reading reset signals successively generated to be equal to nH.

7. A field memory device in accordance with claim 6, wherein
said reading reset signal generating means comprises
means for delaying timing of generation of said reset signal to cause the last interval of the reading reset signals of one cycle of the reading from said memory to be equal to (2m + 1) H near to nH.

8. A field memory device in accordance with claim 7, wherein
said control means (10) comprises
means for shifting timing of generation of said reading reset signal when a period corresponding to a difference between the timing of generation of said writing reset signal (RSTW) and the timing of generation of said reading reset signal (RSTR) is equal to or shorter than a predetermined period.

9. A field memory device in accordance with claim 1, wherein
the writing and the reading of said color television signal into and from said memory (5) are effected in a period shorter than one field period by a predetermined period.

10. A field memory device in accordance with claim 9, wherein
predetermined fixed data and a horizontal synchronizing signal are supplied as memory outputs during said predetermined period in the reading from said memory (5).

## Patentansprüche

1. Halbbild-Speichervorrichtung mit: Mitteln (1) zur Zuführung eines Farbfernsehsignals, in dem zwei unterschiedlich modulierte Farbsignale übertragen werden, wobei in jeder Zeilenperiode eines der beiden unterschiedlich modulierten Farbsignale derart übertragen wird, daß sich die beiden unterschiedlich modulierten Signale jede Zeilenperiode abwechseln, A/D-Wandlermitteln (3) zur A/D-Wandlung des Farbfernsehsignals, einem Speicher (5) zum Speichern des durch die A/D-Wandlung erhaltenen Farbfernsehsignals für im wesentlichen ein Halbbild, Mitteln (4) zur D/A-Wandlung des aus dem Speicher ausgelesenen Farbfernsehsignals zur Ausgabe eines durch die D/A-Wandlung erhaltenen Signals und Mitteln (10) zum Steuern des Schreibens und des Lesens des Farbfernsehsignals in und aus dem Speicher, dadurch **gekennzeichnet**, daß:
die Steuermittel (10) eine Spanne nH definieren, die durch Multiplikation der Horizontalperiode H mit einer Zahl n nahe der Anzahl der Abtastzeilen, die ein Halbbild des Farbfernsehsignals bilden, erhalten wird, und die Leseoperation des Speichers nach einer Periode von im wesentlichen nH zurückstellt, wobei n eine positive ganze Zahl ist, und daβ in zumindest einigen Betriebsmodi die Periode von nH zwischen der Leserückstellung durch Änderung von n variiert wird, um die Kontinuierlichkeit eines Farbburstsignals sicherzustellen.

2. Halbbild-Speichervorrichtung nach Anspruch 1, wobei das Schreiben des Farbfernsehsignals in den Speicher (5) und das Lesen des Farbfernsehsignals aus dem Speicher synchron ausgeführt werden.

3. Halbbild-Speichervorrichtung nach Anspruch 2, wobei die Steuereinrichtung (10) aufweist:
Mittel (31) zur Erzeugung eines Signals (STW) zum Rückstellen der Schreiboperation des Farbfernsehsignals in den Speicher (5) und
Mittel (39) zur Erzeugung eines Signals (RSTR) zum Rückstellen der Leseoperation des Farbfernsehsignals aus dem Speicher (5) mit einer Zeitsteuerung, die sich auf das Schreibrückstellsignal bezieht, und
wobei die Leserückstellsignal-Erzeugungsmittel (38) aufweisen:
Mittel zum Verzögern der Zeitsteuerung der Erzeugung des Rückstellsignals, um ein Intervall von Leserückstellsignalen, die aufeinanderfolgend generiert werden, gleich nH zu gestalten.

4. Halbbild-Speichervorrichtung nach Anspruch 3, wobei die Leserückstellsignal-Erzeugungsmittel (39) aufweisen:
Mittel zur Verzögerung der Zeitsteuerung der Erzeugung des Rückstellsignals, um das Intervall der Leserückstellsignale beim Lesevorgang direkt vor dem Schreiben in dem Speicher gleich (2m+1) H nahe zu nH zu gestalten, wobei m eine positive ganze Zahl ist.

5. Halbbild-Speichervorrichtung nach Anspruch 1, wobei das Schreiben des Farbfernsehsignals in den Speicher (5) und das Lesen des Farbfernsehsignals aus dem Speicher (5) asynchron ausgeführt werden.

6. Halbbild-Speichervorrichtung nach Anspruch 5, wobei die Steuermittel (10) aufweisen:
Mittel (31) zur Erzeugung eines Signals (RSTW) zum Rückstellen des Schreibens des Farbfernsehsignals in den Speicher (5) und
Mittel (54) zur Erzeugung eines Signals zum Rückstellen des Lesens (RSTR) des Farbfernsehsignals aus dem Speicher (5) mit einer Zeitsteuerung, die unabhänging ist von dem Schreibrückstellsignal, und
wobei die Leserückstellsignal-Erzeugungsmittel aufweisen: Mittel zum Verzögern der Zeitsteuerung der Erzeugung des Rückstellsignals, um das Intervall der Leserückstellsignale, die aufeinanderfolgend erzeugt werden, gleich nH zu gestalten.

7. Halbbild-Speichervorrichtung nach Anspruch 6, wobei die Leserückstellsignal-Erzeugungsmittel aufweisen:
Mittel zum Verzögern der Zeitsteuerung der Erzeugung des Rückstellsignals, um das letzte Intervall der Leserückstellsignale eines Zyklus des Lesens aus dem Speicher gleich (2m+1) H nahe zu nH zu gestalten.

8. Halbblild-Speichervorrichtung nach Anspruch 7, wobei die Steuermittel (10) aufweisen:
Mittel zum Verschieben der Zeitsteuerung der Erzeugung des Leserückstellsignals, wenn eine Spanne entsprechend der Differenz der Zeitsteuerung der Erzeugung des Schreibrückstellsignals (RSTW) und der Zeitsteuerung der Erzeugung des Leserückstellsignals (RSTR) gleich oder kürzer als eine vorgegebene Zeitspanne ist.

9. Halbbild-Speichervorrichtung nach Anspruch 1, wobei das Schreiben und das Lesen des Farbfernsehsignals in bzw. aus dem Speicher (5) in einer Spanne ausgeführt werden, die um eine vorgegebene Spanne kürzer als eine Halbbildperiode ist.

10. Halbbild-Speichervorrichtung nach Anspruch 9, wobei vorgegebene feststehende Daten und ein Horizontalsynchronsignal als Speicherausgaben während der vorgegebenen Spanne beim Lesen aus dem Speicher (5) zugeführt werden.

## Revendications

1. Dispositif de mémorisation de trames ou demi-trames comprenant : des moyens (1) pour fournir un signal de télévision en couleurs dans lequel deux signaux de couleurs modulés différents sont transmis, de telle sorte que, lors de chaque période de ligne, on transmette l'un des dits deux signaux de couleurs modulés, de telle sorte que les dits deux signaux de couleurs modulés différents soient alternés à chaque période de ligne ; des moyens (3) de conversion A/D analogique/ numérique pour convertir ledit signal de télévision en couleurs ; une mémoire (5) pour stocker ledit signal de télévision obtenu par la conversion A/D pendant pratiquement une demi-trame ; des moyens (4) de conversion D/A numérique- analogique du signal de télévision lu sur la mémoire (5), pour produire en sortie un signal obtenu par conversion D/A ; et des moyens (10) pour commander l'écriture et la lecture de ladite mémoire (5), caractérisé en ce que :
les dits moyens de commande (10) définissent une période nH obtenue par multiplication de la période horizontale H par un nombre n, proche du nombre de lignes de balayage constituant une demi-trame dans ledit signal de télévision en couleurs et remettent à zéro l'opération de lecture de ladite mémoire, après une période pratiquement égale à nH, n étant un entier positif, et en ce que, au moins dans certains modes de fonctionnement, la période de nH entre les remises à zéro de lecture varie par changement de n afin d'assurer de la continuité dans le signal de chrominance.

2. Dispositif de mémorisation de trames selon la revendication 1, dans lequel l'écriture dudit signal de telévision en couleurs dans la dite mémoire (5) et la lecture dudit signal de télévision en couleurs sur ladite mémoire sont exécutées de manière synchrone.

3. Dispositif de mémorisation de trames selon la revendication 2, dans lequel
lesdits moyens de commande (10) comportent :
des moyens (31) pour générer un signal (RSTW) de remise à zéro de l'opération d'écriture dudit signal de télévision en couleurs dans ladite mémoire (5) et
des moyens (39) pour générer un signal (RSTR) de remise à zéro de lecture dudit signal de télévision en couleurs sur ladite mémoire (5) avec un séquencement associé à celui du signal de remise à zéro d'écriture, et
les dits moyens (39) générateurs de signal de remise à zéro de lecture comportent
des moyens pour retarder le séquencement de la génération dudit signal de remise à zéro pour provoquer la mise à nH d'un intervalle des signaux de remise à zéro de lecture successivement générés.

4. Dispositif de mémorisation de trames selon la revendication 3, dans lequel
les dits moyens générateurs (39) de signal de remise à zéro de lecture comportent
des moyens pour retarder le séquencement de génération dudit signal de remise à zéro de façon à créer un intervalle des signaux de remise à zéro de lecture pour l'opération de lecture immédiatement avant une écriture dans la dite mémoire égal à (2m + 1)H proche de nH, m étant un entier positif.

5. Dispositif de mémorisation de trames selon la revendication 1, dans lequel
l'écriture dudit signal de télévision en couleurs dans ladite mémoire (5) et la lecture dudit signal de télévision en couleurs dans ladite mémoire (5) sont exécutées de manière asynchrone.

6. Dispositif de mémorisation de trames selon la revendication 5, dans lequel
les dits moyens de commande (10) comportent
des moyens (31) pour générer un signal (RSTW) de remise à zéro de l'écriture dudit signal de télévision en couleurs dans ladite mémoire (5) et
des moyens (54) pour générer un signal (RSTR) de remise à zéro de lecture dudit signal de télévision en couleurs dans ladite mémoire (5) avec un séquencement indépendant dudit signal de remise à zéro d'écriture, et
les dits moyens (54) pour générer un signal (RSTR) de remise à zéro de lecture comportent
des moyens pour retarder le séquencement de génération dudit signal de remise à zéro de façon à créer un intervalle des signaux de remise à zéro de lecture égal à nH.

7. Dispositif de mémorisation de trames selon la revendication 6, dans lequel
les dits moyens pour générer un signal de remise à zéro de lecture comportent
des moyens pour retarder le séquencement de génération dudit signal de remise à zéro de façon à créer un dernier intervalle des signaux de remise à zéro de lecture dans ladite mémoire égal à (2m + 1)H, proche de nH.

8. Dispositif de mémorisation de trames selon la revendication 7, dans lequel
les dits moyens de commande (10) comportent
des moyens pour décaler le séquencement de génération dudit signal de remise à zéro de lecture quand une période correspondant à la différence entre le séquencement de génération dudit signal (RSTW) de remise à zéro d'écriture et le séquencement de génération dudit signal (RSTR) de remise à zéro de lecture est égale ou plus petite qu'une période prédéterminée.

9. Dispositif de mémorisation de trames selon la revendication 1, dans lequel
l'écriture et la lecture dudit signal de télévision en couleurs dans ladite mémoire (5) sont effectuées sous une période plus courte que la période d'une demi-trame d'une période prédéterminée.

10. Dispositif de mémorisation de trames selon la revendication 9, dans lequel
des données fixées prédéterminées et un signal de synchronisation horizontale sont fournis comme sorties de la mémoire pendant ladite période prédéterminée lors du lecture de ladite mémoire (5).
